(19) Europäisches Patentamt
European Patent Office
Office européen des brevets

(11) EP 3 781 519 B1

(12) EUROPÄISCHE PATENTSCHRIFT

(45) Veröffentlichungstag und Bekanntmachung des Hinweises auf die Patenterteilung:
**28.09.2022 Patentblatt 2022/39**

(21) Anmeldenummer: **18720189.2**

(22) Anmeldetag: **18.04.2018**

(51) Internationale Patentklassifikation (IPC):
***C01B 33/02** (2006.01)* ***C01B 33/04** (2006.01)*
***C01B 33/107** (2006.01)*

(52) Gemeinsame Patentklassifikation (CPC):
**C01B 33/02; C01B 33/043; C01B 33/1071;**
C01P 2004/53; C01P 2004/61; C01P 2006/80

(86) Internationale Anmeldenummer:
**PCT/EP2018/059933**

(87) Internationale Veröffentlichungsnummer:
**WO 2019/201439 (24.10.2019 Gazette 2019/43)**

(54) **VERFAHREN ZUR HERSTELLUNG VON CHLORSILANEN**

METHOD FOR PRODUCING CHLOROSILANES

PROCÉDÉ DE PRÉPARATION DE CHLOROSILANES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**24.02.2021 Patentblatt 2021/08**

(73) Patentinhaber: **Wacker Chemie AG**
**81737 München (DE)**

(72) Erfinder:
- **RIMBÖCK, Karl-Heinz**
**84431 Heldenstein (DE)**
- **SOFINA, Natalia**
**84489 Burghausen (DE)**

(74) Vertreter: **Belz, Ferdinand et al**
**Wacker Chemie AG**
**Hanns-Seidel-Platz 4**
**81737 München (DE)**

(56) Entgegenhaltungen:
**DE-A1-102008 041 974** **DE-A1-102010 044 108**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Processed by Luminess, 75001 PARIS (FR)

**Beschreibung**

Die Erfindung betrifft ein Verfahren zur Herstellung von Chlorsilanen der allgemeinen Formel $H_nSiCl_{4-n}$ und/oder $H_mCl_{6-m}Si_2$, mit n = 1 bis 4 und m = 0 bis 4, in einem Wirbelschichtreaktor durch Umsetzen eines Chlorwasserstoff enthaltenden Reaktionsgases mit einer Kontaktmasse, die Silicium als eine Körnungsmischung aus einer Grobkornfraktion und einer Feinkornfraktion enthält.

Die Herstellung von polykristallinem Silicium als Ausgangsmaterial für die Fertigung von Chips oder Solarzellen erfolgt üblicherweise durch Zersetzung seiner flüchtigen Halogenverbindungen, insbesondere Chlorsilane wie Trichlorsilan (TCS, $HSiCl_3$). Um den Anforderung für die Fertigung von Chips oder Solarzellen zu genügen, muss das polykristalline Silicium eine Reinheit von mindestens 99,9 % aufweisen. Ab einer Reinheit von mehr als 99,9 % spricht man von Reinstsilicium.

Die Herstellung von Chlorsilanen, insbesondere TCS, kann im Wesentlichen durch drei Verfahren erfolgen, denen folgende Reaktionen zugrunde liegen (vgl. WO 2010/028878 A1 und WO 2016/198264 A1):

(1) $SiCl_4 + H_2$ --> $SiHCl_3 + HCl$ + Nebenprodukte

(2) $Si + 3SiCl_4 + 2H_2$ --> $4SiHCl_3$ + Nebenprodukte

(3) $Si + 3HCl$ --> $SiHCl_3 + H_2$ + Nebenprodukte

Als Nebenprodukte können weitere Halogensilane anfallen, beispielsweise Monochlorsilan ($H_3SiCl$), Dichlorsilan ($H_2SiCl_2$), Siliciumtetrachlorid (STC, $SiCl_4$) sowie Di- und Oligosilane. Ferner können Verunreinigungen wie Kohlenwasserstoffe, Organochlorsilane und Metallchloride Bestandteil der Nebenprodukte sein. Um hochreines TCS zu erzeugen, erfolgt daher anschließend üblicherweise eine Destillation.

Die Hochtemperaturkonvertierung gemäß Reaktion (1) ist ein endothermer Prozess und findet üblicherweise unter hohem Druck bei Temperaturen zwischen 600 und 900°C statt.

Die Niedertemperaturkonvertierung (NTK) gemäß Reaktion (2) wird in Gegenwart eines Katalysators (z.B. kupferhaltige Katalysatoren) durchgeführt. Die NTK kann in einem Wirbelschichtreaktor in Anwesenheit von $Si_{mg}$ bei Temperaturen zwischen 400 und 700°C erfolgen.

Bei der Hydrochlorierung (HC) gemäß Reaktion (3) können aus metallurgischem Silicium ($Si_{mg}$, "metallurgical grade" Silicium) unter Zusatz von Chlorwasserstoff (HCl) Chlorsilane in einem Wirbelschichtreaktor hergestellt werden, wobei die Reaktion exotherm verläuft. Dabei erhält man in der Regel TCS und STC als Hauptprodukte. Ein Verfahren zur HC ist beispielsweise in der US 4092446 A offenbart.

Die wichtigsten Parameter, welche die Performance der HC beeinflussen sind grundsätzlich die TCS-Selektivität, der HCl-Umsatz, der Silicium-Umsatz sowie die Entstehung von Nebenprodukten. Die HC beruht auf thermischen Gleichgewichtsreaktionen von Chlorsilanen wie bspw. von Sirtl et al. (Z. anorg. allg. Chem. 1964, 332, 113-216) oder von Hunt et al. (J. Electrochem. Soc. 1972, 119, 1741-1745) beschrieben wurde. Grundsätzlich entstehen bei der HC in einem thermischen Gleichgewicht neben chlorhaltigen Monosilanen ($H_nCl_{4-n}Si$ mit n = 1-4) auch hochsiedende Di-, Oligo- und/oder Polychlorsilane.

Der Begriff "hochsiedende Verbindung" oder "Hochsieder" bezeichnet dabei Verbindungen, welche aus Silicium, Chlor sowie gegebenenfalls Wasserstoff, Sauerstoff und/oder Kohlenstoff bestehen und einen höheren Siedepunkt als STC (57°C bei 1013 hPa) aufweisen. In der Regel handelt es sich um Disilane $H_mCl_{6-m}Si_2$ (m = 0-4) und höhere Oligo- oder Poly(chlor)silane.

In der WO 2007/101789 A1 und der darin zitierten Literatur werden Verfahren genannt, die Hochsieder wieder zu chlorhaltigen Monosilanen, bevorzugt TCS, umsetzen und diese damit wieder der Wertschöpfungskette zuführen. Diese Verfahren bedeuten jedoch einen zusätzlichen technischen Aufwand. Insbesondere wünschenswert sind daher Verfahren, welche die Bildung unerwünschter Hochsieder direkt bei der Herstellung minimieren oder sogar vermeiden.

Neben einer unerwünscht hohen Bildung von STC und Hochsiedern werden die Verfahrenskosten grundsätzlich auch durch nicht umgesetzten HCl sowie nicht umgesetztes Silicium erhöht.

Es ist bekannt, bei der Herstellung von Chlorsilanen in Wirbelschichtreaktoren gezielt Feinkornanteile der einzusetzenden Siliciumpartikel abzutrennen. Beispielsweise nennen Lobusevich *et al.* eine Arbeitskörnung für Silicium von 70 bis 500 μm, wobei 70 μm die minimale und 500 μm die maximale Korngröße (Korngrößengrenzen oder Bereichsgrenzen) ist und die Zahlenwerte Äquivalenzdurchmesser sind (Khimiya Kremniiorganich. Soed. 1988, 27-35). Die Arbeitskörnung bezeichnet jene Körnung, die in den Wirbelschichtreaktor eingebracht wird. In der DE 3938897 A1 ist eine bevorzugte Arbeitskörnung für Silicium von 50-800 μm und in der RU 2008 128 297 A eine bevorzugte Arbeits-

körnung von 90-450 μm genannt. Lobusevich *et al.* geben an, dass bei der Auswahl der Kontaktmassenkorngröße für die Synthese von Methylchlorsilan, Ethylchlorsilan und TCS die Wechselwirkung zwischen Festkörper und Gas berücksichtigt werden muss, um eine maximale Stabilität und Effizienz des Verfahrens zu erreichen. So wird bei der Synthese von TCS (bei 400°C) für eine Arbeitskörnung von 2 bis 3 mm gegenüber einer Arbeitskörnung von 70 bis 500 μm eine Senkung der Reaktionsgeschwindigkeit um ca. 25 bis 30 % festgestellt. Werden kupferhaltige Katalysatoren zugesetzt, findet die Reaktion mit Siliciumpartikeln der Arbeitsfraktion von 2 bis 3 mm bereits bei 250°C statt. Die Reaktionsgeschwindigkeit entspricht dabei der unkatalysierten Variante bei 400°C. In beiden Fällen - sowohl für die katalysierte als auch für die unkatalysierte Variante - führt die Erhöhung der Siliciumpartikelgröße zu einer erhöhten TCS-Selektivität sowie zu einer verminderten Bildung von Polychlorsilanen (Hochsieder).

Eine Erhöhung der Partikelgröße fordert grundsätzlich einen größeren Energieaufwand, da eine höhere Reaktionstemperatur für die Beschleunigung der Reaktion sowie eine höhere Gasgeschwindigkeit zur Erzeugung der Wirbelschicht erforderlich sind. Zwar geben Lobusevich et *al.* an, dass eine anteilige Verwendung von kleineren Siliciumpartikeln im Sinne einer polydispersen Partikelmischung die Aktivität des Siliciums aufgrund einer erhöhten Oberfläche steigert, allerdings sei die Verwendung von Anteilen an kleinen Siliciumpartikeln mit Schwierigkeiten verbunden, da es zu einem erhöhten Austrag von Siliciumpartikeln aus dem Reaktor sowie zu einer Aggregation der Partikel kommen kann. Deshalb ist es nach Lobusevich et *al.* zielführend, trotz des höheren Energieaufwands die Breite der Korngrößenverteilung der eingesetzten Siliciumpartikel zu verringern und die mittlere Partikelgröße zu erhöhen.

Generell kann die Hydrochlorierungsreaktion zur Herstellung von Chlorsilanen auch in einem Festbettreaktor durchgeführt werden wie in der DE 10 2010 044 108 A1 beschrieben ist.

Der vorliegenden Erfindung lag die Aufgabe zugrunde, ein besonders wirtschaftliches Verfahren zur Chlorsilanherstellung bereitzustellen.

Diese Aufgabe wird gelöst durch ein Verfahren zur Herstellung von Chlorsilanen der allgemeinen Formel $H_nSiCl_{4-n}$ und/oder $H_mCl_{6-m}Si_2$, mit n = 1-4 und m = 0-4, in einem Wirbelschichtreaktor durch Umsetzung eines Chlorwasserstoff enthaltenden Reaktionsgases mit einer Kontaktmasse, die Silicium als eine Körnungsmischung aus einer Grobkornfraktion und einer Feinkornfraktion enthält, wobei die mittlere Partikelgröße der Feinkornfraktion $d_{50,Fein}$ 5 bis 400 μm und die mittlere Partikelgröße der Grobkornfraktion $d_{50,Grob}$ 125 bis 600 μm beträgt mit der Maßgabe, dass $d_{50,Fein}$ kleiner ist als $d_{50,Grob}$.

Unter "Körnung" soll insbesondere eine Mischung aus Siliciumpartikeln verstanden werden, die beispielsweise durch Zerkleinern von stückigem Silicium mittels Brech- und Mahlanlagen hergestellt werden kann. Das stückige Silicium kann eine mittlere Partikelgröße von > 10 mm, bevorzugt > 20 mm, besonders bevorzugt > 50 mm aufweisen. Körnungen lassen sich im Wesentlichen durch Sieben und/oder Sichten in Fraktionen klassieren.

Körnungen können hergestellt werden durch/aus

- Brechen und Mahlen von stückigem Silicium; anschließend ggf. sieben und/oder sichten (Klassieren)
- Abfällen, insbesondere in Form von Stäuben, die bei der Bearbeitung (Brechen, Mahlen, Sägen) verschiedener Siliciumarten (Wafer, poly-/multi-/einkristallines Silicium, $Si_{mg}$) anfallen und ggf. klassiert werden; in Form von Über- und/oder Unterkorn, wobei es sich um Fraktionen handelt, die außerhalb der Zielkörnung liegen,
- Verfahren zur Herstellung von granuliertem $Si_{mg}$ oder polykristallinem Silicium.

Eine Mischung verschiedener Körnungen kann als Körnungsmischung und die Körnungen aus denen die Körnungsmischung besteht als Körnungsfraktionen bezeichnet werden. Körnungsfraktionen können relativ zueinander in Grobkornfraktionen und Feinkornfraktionen eingeteilt werden. Grundsätzlich ist bei einer Körnungsmischung möglich, mehr als eine Körnungsfraktion in Grobkornfraktion und/oder Feinkornfraktion einzuteilen.

Die Differenz ($d_{50,Grob}$ - $d_{50,Fein}$) ist > 1 μm, bevorzugt > 10 μm, besonders bevorzugt > 50 μm, insbesondere > 100 μm. Vorzugsweise liegt die Differenz ($d_{50,Grob}$ - $d_{50,Fein}$) in einem Bereich von 10 bis 700 μm, bevorzugt 50 bis 500 μm, besonders bevorzugt 75 bis 450 μm, insbesondere 100 bis 350 μm.

Die mittlere Partikelgröße der Grobkornfraktion $d_{50,Grob}$ kann bevorzugt 150 bis 500 μm, insbesondere 175 bis 400 μm, betragen.

Die mittlere Partikelgröße der Feinkornfraktion $d_{50,Fein}$ kann bevorzugt 10 bis 300 μm, insbesondere 15 bis 175 μm, betragen.

Gegenüber den üblicherweise eingesetzten Grobkornfraktionen kommt es durch den erfindungsgemäßen Einsatz der Feinkornfraktion zu einer Verschiebung der mittleren Partikelgröße der Körnungsmischung $d_{50,Mischung}$ zugunsten kleinerer Partikelgrößen. Die Partikelgrößenverteilung wird insgesamt breiter.

Überraschenderweise hat sich herausgestellt, dass derartige Körnungsmischungen mit einer breiteren Partikelgrößenverteilung bei mindestens ebenso hoher TCS-Selektivität eine geringere Menge hochsiedender Nebenprodukte erzeugen als dies bei bekannten Verfahren der Fall ist. Das Vorurteil von Lobusevich et *al.,* wonach nur bei Körnungsmischungen mit schmaler Größenverteilung mit zunehmender mittlerer Partikelgröße die TCS-Selektivität steigt und die Bildung von Hochsiedern abnimmt, wird damit überwunden. Des Weiteren hat sich gezeigt, dass mit dem

erfindungsgemäßen Verfahren deutlich höhere HCl-Umsätze erzielt werden können. Die nach bisherigem Kenntnisstand bei einer Verkleinerung der mittleren Partikelgröße zu erwartenden negativen Effekte wie ein erhöhter Austrag von kleineren Siliciumpartikeln aus dem Reaktor und das Auftreten von Aggregationseffekten konnten überraschend nicht beobachtet werden. Vielmehr konnte beim erfindungsgemäßen Verfahren ein verbessertes Wirbelverhalten der Kontaktmasse festgestellt werden. Zudem resultiert aus der Anwesenheit der Feinkornfraktion als weiterer Vorteil ein besseres Fließverhalten der Körnungsmischung, wodurch sich insbesondere deren Transport und Zufuhr zum Reaktor vereinfachen.

Der Wert $d_{50}$ gibt die mittlere Partikelgröße an (vgl. ISO 13320). Der Wert $d_{50}$ bedeutet, dass 50 % der Partikel kleiner sind als der angegebene Wert. Weitere wichtige Parameter für die Charakterisierung einer Partikelgrößenverteilung sind beispielsweise der Wert $d_{10}$, als ein Maß für die kleineren Partikel, sowie der Wert $d_{90}$, als ein Maß für die größeren Partikel in der entsprechenden Fraktion oder Körnungsmischung. Die Werte $d_{10}$ und $d_{90}$ können auch zur Beschreibung der Breite einer Partikelgrößenverteilung herangezogen werden:

$$\text{Breite} = d_{90} - d_{10}$$

Um die relative Breite einer Partikelgrößenverteilung zu bewerten, kann die sogenannte Spanne einer Partikelgrößenverteilung herangezogen werden:

$$\text{Spanne} = (d_{90} - d_{10}) / d_{50}$$

Die Spanne wird grundsätzlich herangezogen, wenn Partikelgrößenverteilungen mit sehr unterschiedlichen mittleren Partikelgrößen verglichen werden sollen.

Die Bestimmung der Partikelgrößenverteilung kann nach ISO 13320 (Laserbeugung) und/oder ISO 13322 (Bildanalyse) erfolgen. Eine Berechnung von mittleren Partikelgrößen/-durchmessern aus Partikelgrößenverteilungen kann nach DIN ISO 9276-2 erfolgen.

Vorzugsweise weist die Körnungsmischung eine p-modale volumengewichtete Verteilungsdichtefunktion auf, wobei p = 1 bis 10, bevorzugt p = 1 bis 6, besonders bevorzugt p = 1 bis 3, insbesondere p = 1 oder 2, ist. Beispielsweise weist eine 2-modale Verteilungsdichtefunktion zwei Maxima auf.

Durch den Einsatz von Körnungsmischungen, die eine vielmodale (bspw. p = 5 bis 10) Verteilungsdichtefunktion aufweisen, können Sichtungseffekte (Separation einzelner Kornfraktionen in der Wirbelschicht, bspw. zweigeteilte Wirbelschicht) vermieden werden. Diese Effekte treten insbesondere dann auf, wenn die Maxima der Verteilungsdichtefunktion der Körnungsmischung weit auseinander liegen.

Des Weiteren kann es bevorzugt sein, dass die Grobkornfraktion und/oder die Feinkornfraktion eine p-modale volumengewichtete Verteilungsdichtefunktion aufweisen, wobei p = 1 bis 5, bevorzugt p = 1 bis 3, besonders bevorzugt p = 1 oder 2, ist.

Wie bereits angemerkt können Feinkornfraktionen aus Silicium mit unterschiedlichen Partikelgrößenverteilungen als Abfallprodukt bei verschiedenen Prozessen anfallen und können zusammengefasst zu einer mehrmodalen ($p \geq 2$) Feinkornfraktion führen. Der Zukauf derartiger Feinkornfraktionen ist üblicherweise günstig und verbessert die Wirtschaftlichkeit des Verfahrens. Die Verwendung solcher Feinkornfraktionen ermöglicht ferner den Gebrauch einer gröberen Standardarbeitsfraktion, so dass Kapazitäten bei Mahlanlagen frei werden.

$d_{50,Fein}$ und $d_{50,Grob}$ liegen in einem Korngrößenverhältnis (KGV) $d_{50,Fein}/d_{50,Grob}$ von 0,02 bis 0,9, bevorzugt von 0,03 bis 0,7, insbesondere von 0,04 bis 0,6, vor. Das KGV kann auch als Partikelgrößenverhältnis bezeichnet werden.

Die Feinkornfraktion und die Grobkornfraktion liegen in einem Massenverhältnis (MV) *m(Fein)/m(Grob)* von 0,05 bis 20, bevorzugt von 0,09 bis 10, insbesondere von 0,1 bis 4, vor.

Die Körnungsmischung weist eine Spanne der Partikelgrößenverteilung $(d_{90}-d_{10})/d_{50}$ von 1 bis 100, insbesondere von 1,5 bis 10, auf.

Bei der Kontaktmasse handelt es sich insbesondere um die Körnungsmischung. Vorzugsweise umfasst die Kontaktmasse also keine weiteren Komponenten. Bevorzugt handelt es sich um Silicium, das höchstens 5 Gew.-%, besonders bevorzugt höchstens 2 Gew.-%, insbesondere höchstens 1 Gew.-%, andere Elemente als Verunreinigungen enthält. Vorzugsweise handelt es sich um $Si_{mg}$, das üblicherweise eine Reinheit von 98 bis 99,9 % aufweist. Typisch ist beispielsweise eine Zusammensetzung mit 98 % Silicium, wobei sich die übrigen 2 % in der Regel zum größten Teil aus den folgenden Elementen zusammensetzen: Fe, Ca, Al, Ti, Cu, Mn, Cr, V, Ni, Mg, B, C, P und O. Ferner können folgende Elemente enthalten sein: Co, W, Mo, As, Sb, Bi, S, Se, Te, Zr, Ge, Sn, Pb, Zn, Cd, Sr, Ba, Y und Cl. Es ist allerdings auch die Verwendung von Silicium einer geringeren Reinheit von 75 bis 98 % möglich. Vorzugsweise ist jedoch der Siliciumanteil größer als 75 %, bevorzugt größer als 85 %, besonders bevorzugt größer als 85 %.

Einige der als Verunreinigung im Silicium vorliegenden Elemente weisen eine katalytische Aktivität auf. Daher

ist der Zusatz eines Katalysators grundsätzlich nicht erforderlich. Allerdings kann das Verfahren durch die Gegenwart eines zusätzlichen Katalysators positiv beeinflusst werden, insbesondere hinsichtlich seiner Selektivität.

Gemäß einer Ausführungsform handelt es sich bei dem eingesetzten Silicium um eine Mischung aus $Si_{mg}$ und Reinstsilicium (Reinheit > 99,9 %). Anders ausgedrückt handelt es sich also um eine Körnungsmischung, die $Si_{mg}$ und Reinstsilicium umfasst. Vorzugsweise beträgt dabei der Anteil an $Si_{mg}$ mindestens 50 Gew.-%, bevorzugt mindestens 70 Gew.-%, besonders bevorzugt mindestens 90 Gew.-%, bezogen auf das Gesamtgewicht der Körnungsmischung. Insbesondere ist das Reinstsilicium Bestandteil der Feinkornfraktion. Ferner kann die Feinkornfraktion ausschließlich Reinstsilicium enthalten.

Gemäß einer weiteren Ausführungsform handelt es sich bei dem eingesetzten Silicium um $Si_{mg}$ und Reinstsilicium, wobei der Anteil an $Si_{mg}$ kleiner ist als 50 Gew.-%, bezogen auf das Gesamtgewicht der Körnungsmischung. Vorzugsweise umfasst dabei die Körnungsmischung bzw. die Kontaktmasse zusätzlich einen Katalysator. Das Reinstsilicium und/oder der Katalysator sind bevorzugt Bestandteile der Feinkornfraktion. Vorzugsweise besteht die Feinkornfraktion aus Reinstsilicium.

Gemäß einer anderen Ausführungsform handelt es sich bei dem eingesetzten Silicium ausschließlich um Reinstsilicium und die Kontaktmasse bzw. Körnungsmischung enthält einen Katalysator. Vorzugsweise ist dabei der Katalysator Bestandteil der Feinkornfraktion.

Bei der Feinkornfraktion kann es sich beispielsweise um ein Nebenprodukt handeln, das bei der Abscheidung von polykristallinem Silicium nach dem Siemens- oder Granulatverfahren anfällt. Ferner kann es sich um ein Nebenprodukt handeln, das bei der mechanischen Bearbeitung von poly-/multi- oder einkristallinem Silicium (Reinheit > 99,9 %) anfällt. Der als Nebenprodukt anfallende Reinstsiliciumstaub kann einem Mahlprozess unterzogen werden, um eine gewünschte Partikelgröße zu erhalten und/oder einem Klassierungsprozess, um eine Körnung mit gewünschten Korngrößengrenzen zu erhalten.

Grundsätzlich lässt sich Reinstsilicium bereits unter Anwesenheit geringer Mengen eines der Elemente Cobalt, Molybdän und Wolfram (in der Regel bereits als Verunreinigung in Reinstsilicium enthalten) durch HC umsetzen. Eine gemeinsame Umsetzung mit $Si_{mg}$, welches größere Mengen der katalytisch aktiven Elemente als Verunreinigung enthält, ist nicht zwingend erforderlich. Allerdings kann durch Zusatz eines Katalysators die Chlorsilanselektivität noch erhöht werden. Bei dem vorliegenden Verfahren kann dies insbesondere dann der Fall sein, wenn der Anteil an Reinstsilicium in der Körnungsmischung größer ist als der Anteil an $Si_{mg}$ und/oder wenn die Körnungsmischung ausschließlich Reinstsilicium umfasst.

Bei dem Katalysator kann es sich um ein oder mehrere Elemente aus der Gruppe mit Fe, Cr, Ni, Co, Mn, W, Mo, V, P, As, Sb, Bi, O, S, Se, Te, Ti, Zr, C, Ge, Sn, Pb, Cu, Zn, Cd, Mg, Ca, Sr, Ba, B, Al, Y, Cl handeln. Vorzugsweise ist der Katalysator ausgewählt aus der Gruppe mit Fe, Al, Ca, Ni, Mn, Cu, Zn, Sn, C, V, Ti, Cr, B, P, O, Cl und Mischungen daraus. Wie bereits erwähnt sind diese katalytisch aktiven Elemente bereits in Silicium als Verunreinigung in einem bestimmten Anteil enthalten, beispielsweise in oxidischer oder metallischer Form, als Silicide oder in anderen metallurgischen Phasen, oder als Oxide oder Chloride. Ihr Anteil hängt von der Reinheit des verwendeten Siliciums ab.

Der Katalysator kann beispielsweise in metallischer, legierter und/oder salzartiger Form der Kontaktmasse zugesetzt werden. Dabei kann es sich insbesondere um Chloride und/oder Oxide der katalytisch aktiven Elemente handeln. Bevorzugte Verbindungen sind CuCl, $CuCl_2$, CuO oder Mischungen daraus. Die Kontaktmasse kann ferner Promotoren enthalten, beispielsweise Zn und/oder Zinkchlorid.

Die elementare Zusammensetzung des eingesetzten Siliciums und der Kontaktmasse kann beispielsweise mittels Röntgenfluoreszenzanalyse erfolgen.

Vorzugsweise werden die Feinkornfraktion und die Grobkornfraktion als vorgefertigte Körnungsmischung dem Wirbelschichtreaktor zugeführt. Gegebenenfalls vorhandene weitere Bestandteile der Kontaktmasse können ebenfalls enthalten sein. Durch den erfindungsgemäß höheren Feinkornanteil ergibt sich ein besseres Fließ- und damit Förderverhalten der fertigen Körnungsmischung.

Die Feinkornfraktion und die Grobkornfraktion können auch separat, insbesondere über getrennte Zuleitungen und Behälter, dem Wirbelschichtreaktor zugeführt werden. Die Durchmischung erfolgt dann grundsätzlich bei Ausbildung der Wirbelschicht (*in situ*). Gegebenenfalls vorhandene weitere Bestandteile der Kontaktmasse können ebenfalls separat oder als Bestandteil einer der beiden Kornfraktionen zugeführt werden.

Das Verfahren wird vorzugsweise bei einer Temperatur von 280 bis 400°C, bevorzugt 320 bis 380°C, besonders bevorzugt 340 bis 360°C, durchgeführt. Der Druck im Wirbelschichtreaktor beträgt vorzugsweise 0,01 bis 0,6 MPa, bevorzugt 0,03 bis 0,35 MPa, besonders bevorzugt 0,05 bis 0,3 MPa.

Das Reaktionsgas enthält vorzugsweise mindestens 50 Vol.-%, bevorzugt mindestens 70 Vol.-%, besonders bevorzugt mindestens 90 Vol.-%, HCl. Neben HCl kann das Reaktionsgas ferner ein oder mehrere Komponenten ausgewählt aus der Gruppe mit $H_2$, $H_nSiCl_{4-n}$ (n = 0 bis 4), $H_mCl_{6-m}Si_2$ (m = 0 bis 6), $H_qCl_{6-q}Si_2O$ (q = 0 bis 4), $CH_4$, $C_2H_6$, CO, $CO_2$, $O_2$, $N_2$ enthalten. Diese Komponenten können aus in einem Verbund zurückgewonnenem HCl stammen. HCl und Silicium liegen vorzugsweise in einem Molverhältnis HCl/Si von 5:1 bis 3:1, bevorzugt 4:1 bis 3:1, besonders bevorzugt 3,6:1 bis 3:1, insbesondere von 3,4:1 bis 3,1:1, vor. HCl und die Kontaktmasse bzw. die Körnungsmischung

oder deren Kornfraktionen werden insbesondere während der Reaktion derart kontinuierlich zugegeben, dass sich das oben genannte Verhältnis einstellt.

Vorzugsweise beträgt ein Quotient aus Wirbelschichthöhe zu Reaktordurchmesser 10:1 bis 1:1, bevorzugt 8:1 bis 2:1, besonders bevorzugt 6:1 bis 3:1. Bei der Wirbelschichthöhe handelt es sich um die Dicke oder Ausdehnung der Wirbelschicht.

Bei den mit dem erfindungsgemäßen Verfahren hergestellten Chlorsilanen handelt es sich bevorzugt um mindestens ein Chlorsilan ausgewählt aus der Gruppe mit Monochlorsilan, Dichlorsilan, TCS, $Si_2Cl_6$ und $HSi_2Cl_5$. Besonders bevorzugt handelt es sich um TCS.

Das erfindungsgemäße Verfahren ist vorzugsweise in einen Verbund zur Herstellung von polykristallinem Silicium eingebunden. Der Verbund umfasst insbesondere folgende Prozesse:

- Erzeugung von TCS gemäß dem beschriebenen Verfahren.
- Aufreinigung des erzeugten TCS zu TCS mit Halbleiterqualität.
- Abscheidung von polykristallinem Silicium, bevorzugt nach dem Siemens-Verfahren oder als Granulat.
- Weiterverarbeitung des erhaltenen polykristallinen Siliciums.
- Recycling des bei der Herstellung/Weiterverarbeitung des polykristallinen Siliciums anfallenden Reinstsiliciumstaubs durch Umsetzen gemäß dem beschriebenen Verfahren.

Fig. 1 zeigt beispielhaft einen Wirbelschichtreaktor 1 zur Durchführung des erfindungsgemäßen Verfahrens. Das Reaktionsgas 2 wird vorzugsweise von unten und gegebenenfalls von der Seite (z.B. tangential oder orthogonal zum Gasstrom von unten) in die Kontaktmasse eingeblasen, wodurch die Partikel der Kontaktmasse fluidisiert werden und eine Wirbelschicht 3 bilden. In der Regel wird zum Starten der Reaktion mittels einer außerhalb des Reaktors angeordneten Heizvorrichtung (nicht dargestellt) die Wirbelschicht 3 beheizt. Während des kontinuierlichen Betriebs ist üblicherweise kein Heizen erforderlich. Ein Teil der Partikel wird mit der Gasströmung aus der Wirbelschicht 3 in den Freiraum 4 oberhalb der Wirbelschicht 3 transportiert. Der Freiraum 4 ist durch eine sehr geringe Feststoffdichte gekennzeichnet, wobei diese in Richtung Reaktoraustritt abnimmt.

**Beispiele**

Die Beispiele wurden in einem Wirbelschichtreaktor, wie beispielsweise in der US4092446 beschrieben, durchgeführt.

In allen Beispielen wurden Feinkornfraktionen und/oder Grobkornfraktionen derselben Siliciumsorte hinsichtlich Reinheit, Qualität und Gehalt an Nebenelementen/Verunreinigungen eingesetzt. Die Kornfraktionen wurden durch Brechen von stückigem $Si_{mg}$ und anschließendem Mahlen hergestellt. Gegebenenfalls wurde abschließend noch durch Sieben klassiert. Die Bestimmung der Partikelgrößenverteilung erfolgte gemäß ISO 13320 und/oder ISO 13322. Bei allen Beispielen wurde das folgende Verfahren angewandt.

Allgemeiner Verfahrensverlauf:

Zunächst wurde ein vorgelegtes Bett aus Kontaktmasse so lange mit Stickstoff (Trägergas) durchströmt bis sich eine Wirbelschicht ausbildete. Der Quotient aus Wirbelschichthöhe zu Reaktordurchmesser wurde auf einen Wert von etwa 5 eingestellt. Der Reaktordurchmesser betrug etwa 1 m. Die Wirbelschicht wurde mit einer externen Heizvorrichtung auf eine Temperatur von ca. 320°C gebracht. Diese Temperatur wurde mit Hilfe einer Kühlung über den gesamten Versuchszeitraum in etwa konstant gehalten. HCl wurde so zugegeben und die Kontaktmasse so nachdosiert, dass die Höhe der Wirbelschicht über den gesamten Versuchszeitraum im Wesentlichen konstant blieb und sich ein konstantes Molverhältnis der Reaktanden (HCl:Si) von 3:1 einstellte. Der Druck im Reaktor betrug über die gesamte Versuchszeit 0,1 MPa Überdruck. Nach 48 h und 49 h Laufzeit wurden jeweils sowohl eine Flüssigkeitsprobe als auch eine Gasprobe entnommen. Die kondensierbaren Anteile des Produktgasstroms (Chlorsilangasstrom) wurden über eine Kühlfalle bei -40°C kondensiert und mittels Gaschromatographie (GC) analysiert und daraus die TCS-Selektivität sowie der Anteil an Hochsiedern [Gew.-%] bestimmt. Die Detektion erfolgte über einen Wärmeleitfähigkeitsdetektor. Der nicht kondensierbare Anteil des Produktgasstroms wurde mit einem Infrarot-Spektrometer auf nicht umgesetzten HCl [Vol.-%] analysiert. Aus den erhaltenen Werten nach 48 und 49 h wurden jeweils die Mittelwerte gebildet. Nach jedem Durchlauf wurde der Reaktor vollständig entleert und neu mit Kontaktmasse befüllt.

Vergleichsbeispiel 1:

Die Kontaktmasse bestand ausschließlich aus einer Grobkornfraktion $Si_{mg}$ ($d_{50}$ = 683 μm, Bereichsgrenzen: 600-700 μm) mit einer schmalen Partikelgrößenverteilung (Spanne: 0,09, mit $d_{10}$ = 631 μm und $d_{90}$ = 694 μm).

Folgende Werte wurden erhalten:

- Anteil an nicht umgesetztem HCl: 32 Vol.-%
- TCS-Selektivität: 91 %
- Anteil an Hochsiedern: 0,7 Gew.-%

Vergleichsbeispiel 2:

Die Kontaktmasse bestand ausschließlich aus einer Grobkornfraktion $Si_{mg}$ ($d_{50}$ = 211 µm, Bereichsgrenzen: 90-450 µm) mit einer breiteren Partikelgrößenverteilung (Spanne: 1,62, mit $d_{10}$ = 95 µm und $d_{90}$ = 437 µm).
Folgende Werte wurden erhalten:

- Anteil an nicht umgesetztem HCl: 16 Vol.-%
- TCS-Selektivität: 88 %
- Anteil an Hochsiedern: 0,7 Gew.-%

Vergleichsbeispiel 3:

Die Kontaktmasse bestand ausschließlich aus einer Feinkornfraktion $Si_{mg}$ ($d_{50}$ = 48,6 µm, Bereichsgrenze: < 90 µm). Die Spanne der Partikelgrößenverteilung betrug 1,35 ($d_{10}$ = 18,9 µm und $d_{90}$ = 84,3 µm).
Folgende Werte wurden erhalten:

- Anteil an nicht umgesetztem HCl: 0,7 Vol.-%
- TCS-Selektivität: 74 %
- Anteil an Hochsiedern: 0,6 Gew.-%

Ausführungsbeispiel 1:

Die Kontaktmasse bestand aus einer Körnungsmischung (KM) $Si_{mg}$ enthaltend eine Feinkorn- und eine Grobkornfraktion (KGV: 0,12, mit $d_{50,Fein}$ = 50,4 µm und $d_{50,Grob}$ = 420 µm; MV: 0,43; Spanne: 5,22, mit $d_{10,KM}$ = 46,0 µm und $d_{90,KM}$ = 840 µm). Die $d_{50}$ der KM betrug 152 µm. Die fertige KM wurde als Bett im Reaktor vorgelegt und während des Verfahrens kontinuierlich zugeführt.
Folgende Werte wurden erhalten:

- Anteil an nicht umgesetztem HCl: 4 Vol.-%
- TCS-Selektivität: 89 %
- Anteil an Hochsiedern: 0,2 Gew.-%

Ausführungsbeispiel 2:

Die Kontaktmasse bestand aus einer Körnungsmischung (KM) $Si_{mg}$ enthaltend eine Feinkorn- und eine Grobkornfraktion (KGV: 0,12, mit $d_{50,Fein}$ = 50,4 µm und $d_{50,Grob}$ = 420 µm; MV: 1,0; Spanne: 7,51, mit $d_{10,KM}$ = 34,0 µm und $d_{90,KM}$ = 680 µm). Die $d_{50}$ der KM betrug 86 µm. Die fertige KM wurde als Bett im Reaktor vorgelegt und während des Verfahrens kontinuierlich zugeführt.
Folgende Werte wurden erhalten:

- Anteil an nicht umgesetztem HCl: 2 Vol.-%
- TCS-Selektivität: 88 %
- Anteil an Hochsiedern: 0,1 Gew.-%

Die Ergebnisse belegen, dass durch das erfindungsgemäße Verfahren die Bildung von Hochsiedern vermindert wird. Die TCS-Selektivität ist gegenüber den Vergleichsbeispielen auf ähnlich hohem Niveau.

**Patentansprüche**

**1.** Verfahren zur Herstellung von Chlorsilanen der allgemeinen Formel $H_nSiCl_{4-n}$ und/oder $H_mCl_{6-m}Si_2$, mit n = 1-4 und m = 0-4, in einem Wirbelschichtreaktor durch Umsetzung eines Chlorwasserstoff enthaltenden Reaktionsgases mit einer Kontaktmasse, die Silicium als eine Körnungsmischung aus einer Grobkornfraktion und einer Feinkornfraktion enthält, wobei die mittlere Partikelgröße der Feinkornfraktion $d_{50,Fein}$ 5 bis 400 µm und die mittlere Partikelgröße

der Grobkornfraktion $d_{50,Grob}$ 125 bis 600 µm beträgt mit der Maßgabe, dass $d_{50,Fein}$ kleiner ist als $d_{50,Grob}$ und die Differenz $d_{50,Grob}$ - $d_{50,Fein}$ größer als 1 µm ist, wobei $d_{50,Fein}$ und $d_{50,Grob}$ in einem Korngrößenverhältnis $d_{50,Fein}/d_{50,Grob}$ von 0,02 bis 0,9 vorliegen, die Feinkornfraktion und die Grobkornfraktion in einem Massenverhältnis *m(Fein)*/*m(Grob)* von 0,05 bis 20 vorliegen und wobei die Körnungsmischung eine Spanne der Partikelverteilung $d_{90}$-$d_{10}/d_{50}$ von 1 bis 100 aufweist.

**2.** Verfahren nach Anspruch 1, **dadurch gekennzeichnet, dass** die Körnungsmischung eine p-modale volumengewichtete Verteilungsdichtefunktion aufweist, mit p = 1 bis 10, bevorzugt p = 1 bis 6, besonders bevorzugt p = 1 bis 3, insbesondere p = 1 oder 2.

**3.** Verfahren nach Anspruch 1 oder 2, **dadurch gekennzeichnet, dass** $d_{50,Fein}$ und $d_{50,Grob}$ in einem Korngrößenverhältnis $d_{50,Fein}/d_{50,Grob}$ von 0,03 bis 0,7, insbesondere von 0,04 bis 0,6, vorliegen.

**4.** Verfahren nach einem der vorhergehenden Ansprüche, **dadurch gekennzeichnet, dass** die Feinkornfraktion und die Grobkornfraktion in einem Massenverhältnis *m(Fein)*/*m(Grob)* von 0,09 bis 10, insbesondere von 0,1 bis 4, vorliegen.

**5.** Verfahren nach einem der vorhergehenden Ansprüche, **dadurch gekennzeichnet, dass** die Körnungsmischung eine Spanne der Partikelverteilung $d_{90}$-$d_{10}/d_{50}$ von 1,5 bis 10 aufweist.

**6.** Verfahren nach einem der vorhergehenden Ansprüche, **dadurch gekennzeichnet, dass** es sich bei dem Silicium um metallurgisches Silicium und Reinstsilicium handelt, wobei der Anteil an metallurgischem Silicium mindestens 50 Gew.-%, bevorzugt mindestens 70 Gew.-%, besonders bevorzugt mindestens 90 Gew.-%, beträgt, bezogen auf das Gesamtgewicht der Kontaktmasse.

**7.** Verfahren nach Anspruch 6, **dadurch gekennzeichnet, dass** das Reinstsilicium Bestandteil der Feinkornfraktion ist.

**8.** Verfahren nach einem der Ansprüche 1 bis 5, **dadurch gekennzeichnet, dass** es sich bei dem Silicium um metallurgisches Silicium und Reinstsilicium handelt, wobei der Anteil an metallurgischem Silicium kleiner ist als 50 Gew.-% und die Körnungsmischung zusätzlich einen Katalysator enthält.

**9.** Verfahren nach Anspruch 8, **dadurch gekennzeichnet, dass** das Reinstsilicium und/oder der Katalysator Bestandteile der Feinkornfraktion sind.

**10.** Verfahren nach einem der Ansprüche 1 bis 5, **dadurch gekennzeichnet**, es sich bei dem Silicium um Reinstsilicium handelt und die Körnungsmischung einen Katalysator enthält, wobei vorzugsweise der Katalysator Bestandteil der Feinkornfraktion ist.

**11.** Verfahren nach einem der vorhergehenden Ansprüche, **dadurch gekennzeichnet, dass** die Feinkornfraktion und die Grobkornfraktion als vorgefertigte Körnungsmischung dem Wirbelschichtreaktor zugeführt werden.

**12.** Verfahren nach einem der vorhergehenden Ansprüche, **dadurch gekennzeichnet, dass** die Feinkornfraktion und die Grobkornfraktion jeweils separat dem Wirbelschichtreaktor zugeführt werden.

**13.** Verfahren nach einem der vorhergehenden Ansprüche, **dadurch gekennzeichnet, dass** ein Quotient aus Wirbelschichthöhe zu Reaktordurchmesser 10:1 bis 1:1, bevorzugt 8:1 bis 2:1, besonders bevorzugt 6:1 bis 3:1, beträgt.

**14.** Verfahren nach einem der vorhergehenden Ansprüche, **dadurch gekennzeichnet, dass** die Chlorsilane ausgewählt sind aus der Gruppe mit Monochlorsilan, Dichlorsilan, Trichlorsilan, $Si_2Cl_6$, $HSi_2Cl_5$ und Mischungen daraus.

**15.** Verfahren nach einem der vorhergehenden Ansprüche, **dadurch gekennzeichnet, dass** es in einen Verbund zur Herstellung von polykristallinem Silicium eingebunden ist.

## Claims

**1.** Process for producing chlorosilanes of general formula $H_nSiCl_{4-n}$ and/or $H_mCl_{6-m}Si_2$, where n = 1-4 and m = 0-4, in a fluidized bed reactor by reaction of a hydrogen chloride-containing reaction gas with a contact mass which contains

silicon as a granulation mixture composed of a coarse grain fraction and a fine grain fraction, wherein the average particle size of the fine grain fraction $d_{50,fine}$ is 5 to 400 μm and the average particle size of the coarse grain fraction $d_{50,coarse}$ is 125 to 600 μm, with the proviso that $d_{50,fine}$ is smaller than $d_{50,coarse}$ and the difference $d_{50,coarse}$ $d_{50,file}$ is greater than 1 μm, wherein $d_{50,fine}$ and $d_{50,coarse}$ are present in a grain size ratio $d_{50,file}/d_{50,coarse}$ of 0.02 to 0.9, the fine grain fraction and the coarse grain fraction are present in a mass ratio *m(fine) /m(coarse)* of 0.05 to 20, and wherein the granulation mixture has a span of the particle size distribution $d_{90}$-$d_{10}/d_{50}$ of 1 to 100.

**2.** Process according to Claim 1, **characterized in that** the granulation mixture has a p-modal, volume-weighted distribution density function, where p = 1 to 10, preferably p = 1 to 6, particularly preferably p = 1 to 3, in particular p = 1 or 2.

**3.** Process according to Claim 1 or 2, **characterized in that** $d_{50,fine}$ and $d_{50,coarse}$ are present in a grain size ratio $d_{50,fine}/d_{50,coarse}$ of 0.03 to 0.7, in particular of 0.04 to 0.6.

**4.** Process according to any of the preceding claims, **characterized in that** the fine grain fraction and the coarse grain fraction are present in a mass ratio *m(fine)/m(coarse)* of 0.09 to 10, in particular of 0.1 to 4.

**5.** Process according to any of the preceding claims, **characterized in that** the granulation mixture has a span of the particle size distribution $d_{90}$-$d_{10}/d_{50}$ of 1.5 to 10.

**6.** Process according to any of the preceding claims, **characterized in that** the silicon is metallurgical silicon and ultrahigh purity silicon, wherein the proportion of metallurgical silicon is at least 50% by weight, preferably at least 70% by weight, particularly preferably at least 90% by weight, based on the total weight of the contact mass.

**7.** Process according to Claim 6, **characterized in that** the ultrahigh purity silicon is a constituent of the fine grain fraction.

**8.** Process according to any of Claims 1 to 5, **characterized in that** the silicon is metallurgical silicon and ultrahigh purity silicon, wherein the proportion of metallurgical silicon is less than 50% by weight and the granulation mixture additionally contains a catalyst.

**9.** Process according to Claim 8, **characterized in that** the ultrahigh purity silicon and/or the catalyst are constituents of the fine grain fraction.

**10.** Process according to any of Claims 1 to 5, **characterized in that** the silicon is ultrahigh purity silicon and the granulation mixture contains a catalyst, wherein the catalyst is preferably a constituent of the fine grain fraction.

**11.** Process according to any of the preceding claims, **characterized in that** the fine grain fraction and the coarse grain fraction are supplied to the fluidized bed reactor as a pre-prepared granulation mixture.

**12.** Process according to any of the preceding claims, **characterized in that** the fine grain fraction and the coarse grain fraction are each supplied to the fluidized bed reactor separately.

**13.** Process according to any of the preceding claims, **characterized in that** a quotient of fluidized bed height to reactor diameter is 10:1 to 1:1, preferably 8:1 to 2:1, particularly preferably 6:1 to 3:1.

**14.** Process according to any of the preceding claims, **characterized in that** the chlorosilanes are selected from the group comprising monochlorosilane, dichlorosilane, trichlorosilane, $Si_2Cl_6$, $HSi_2Cl_5$ and mixtures thereof.

**15.** Process according to any of the preceding claims, **characterized in that** it is integrated into an integrated system for producing polycrystalline silicon.

**Revendications**

**1.** Procédé pour la préparation de chlorosilanes de formule générale $H_nSiCl_{4-n}$ et/ou $H_mCl_{6-m}Si_2$, où n = 1-4 et m = 0-4, dans un réacteur à couche tourbillonnante par transformation d'un gaz de réaction contenant du chlorure d'hydrogène avec une masse de contact, qui contient du silicium sous forme d'un mélange de grains constitué par

une fraction de gros grains et une fraction de grains fins, la grosseur moyenne de particule de la fraction de grains fins $d_{50,Fin}$ étant de 5 à 400 µm et la grosseur moyenne de particule de la fraction de gros grains $d_{50,Gros}$ étant de 125 à 600 µm, à condition que $d_{50,Fin}$ soit inférieure à $d_{50,Gros}$ et que la différence $d_{50,Gros}$ - $d_{50,Fin}$ soit supérieure à 1 µm, $d_{50,Fin}$ et $d_{50,Gros}$ se trouvant dans un rapport de grosseurs de grain $d_{50,Fin}/d_{50,Gros}$ de 0,02 à 0,9, la fraction de grains fins et la fraction de gros grains se trouvant dans un rapport massique m(Fin)/m(Gros) de 0,05 à 20 et le mélange de grains présentant un intervalle de la répartition des particules $d_{90}$-$d_{10}/d_{50}$ de 1 à 100.

**2.** Procédé selon la revendication 1, **caractérisé en ce que** le mélange de grains présente une fonction de densité de répartition pondérée en volume p-modale, avec p = 1 à 10, de préférence p = 1 à 6, de manière particulièrement préférée p = 1 à 3, en particulier p = 1 ou 2.

**3.** Procédé selon la revendication 1 ou 2, **caractérisé en ce que** $d_{50,Fin}$ et $d_{50,Gros}$ se trouvent dans un rapport de grosseurs de grain $d_{50,Fin}/d_{50,Gros}$ de 0,03 à 0,7, en particulier de 0,04 à 0,6.

**4.** Procédé selon l'une quelconque des revendications précédentes, **caractérisé en ce que** la fraction de grains fins et la fraction de gros grains se trouvent dans un rapport massique m(Fin)/m(Gros) de 0,09 à 10, en particulier de 0,1 à 4.

**5.** Procédé selon l'une quelconque des revendications précédentes, **caractérisé en ce que** le mélange de grains présente un intervalle de la répartition des particules $d_{90}$-$d_{10}/d_{50}$ de 1,5 à 10.

**6.** Procédé selon l'une quelconque des revendications précédentes, **caractérisé en ce qu'**il s'agit, pour le silicium, de silicium métallurgique et de silicium pur, la proportion de silicium métallurgique étant d'au moins 50% en poids, de préférence d'au moins 70% en poids, de manière particulièrement préférée d'au moins 90% en poids, par rapport au poids total de la masse de contact.

**7.** Procédé selon la revendication 6, **caractérisé en ce que** le silicium pur fait partie de la fraction de grains fins.

**8.** Procédé selon l'une quelconque des revendications 1 à 5, **caractérisé en ce qu'**il s'agit, pour le silicium, de silicium métallurgique et de silicium pur, la proportion de silicium métallurgique étant inférieure à 50% en poids et le mélange de grains contenant en outre un catalyseur.

**9.** Procédé selon la revendication 8, **caractérisé en ce que** le silicium pur et/ou le catalyseur font partie de la fraction de grains fins.

**10.** Procédé selon l'une quelconque des revendications 1 à 5, **caractérisé en ce qu'**il s'agit, pour le silicium, de silicium pur et le mélange de grains contient un catalyseur, le catalyseur faisant de préférence partie de la fraction de grains fins.

**11.** Procédé selon l'une quelconque des revendications précédentes, **caractérisé en ce que** la fraction de grains fins et la fraction de gros grains sont introduites dans le réacteur à couche tourbillonnante sous forme de mélange de grains préparé au préalable.

**12.** Procédé selon l'une quelconque des revendications précédentes, **caractérisé en ce que** la fraction de grains fins et la fraction de gros grains sont introduites à chaque fois séparément dans le réacteur à couche tourbillonnante.

**13.** Procédé selon l'une quelconque des revendications précédentes, **caractérisé en ce qu'**un quotient de la hauteur de la couche tourbillonnante au diamètre du réacteur est de 10:1 à 1:1, de préférence de 8:1 à 2:1, de manière particulièrement préférée de 6:1 à 3:1.

**14.** Procédé selon l'une quelconque des revendications précédentes, **caractérisé en ce que** les chlorosilanes sont choisis dans le groupe constitué par le monochlorosilane, le dichlorosilane, le trichlorosilane, $Si_2Cl_6$, $HSi_2Cl_5$ et leurs mélanges.

**15.** Procédé selon l'une quelconque des revendications précédentes, **caractérisé en ce qu'**il est intégré dans un ensemble destiné à la préparation de silicium polycristallin.

Fig. 1

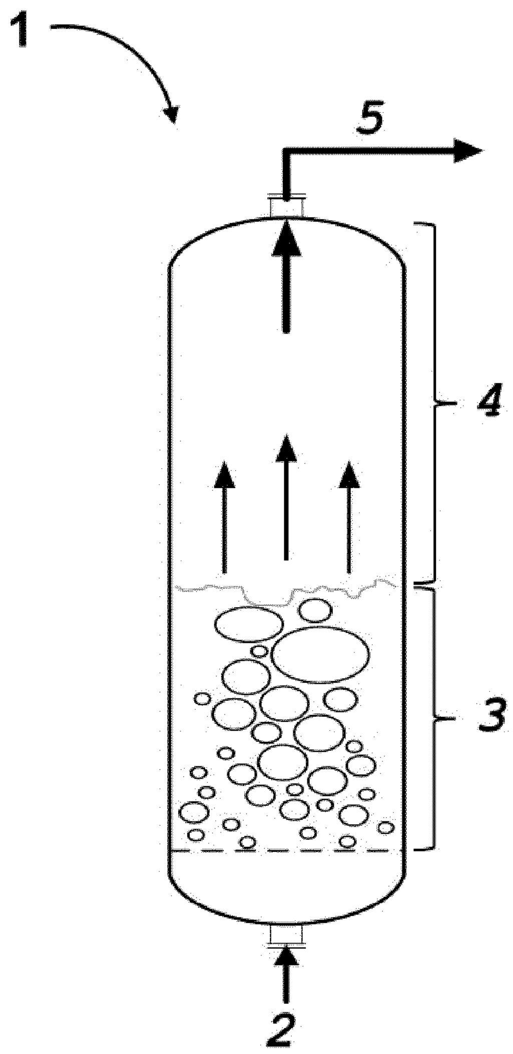

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2010028878 A1
- WO 2016198264 A1
- US 4092446 A
- WO 2007101789 A1
- DE 3938897 A1
- RU 2008128297 A
- DE 102010044108 A1


### In der Beschreibung aufgeführte Nicht-Patentliteratur


- **SIRTL et al.** *Z. anorg. allg. Chem.,* 1964, vol. 332, 113-216
- **HUNT et al.** *J. Electrochem. Soc.,* 1972, vol. 119, 1741-1745